# EUROPEAN PATENT APPLICATION

(11) **EP 4 776 763 A1**
(43) Date of publication of application: **15.07.2026**
(21) Application number: 25221267.5
(22) Date of filing: 05.12.2025
(51) Int. Cl.: H05K 7/14

(54) **INVERTER AND PHOTOVOLTAIC SYSTEM**

(30) Priority: 10.12.2024 CN 202411813910
(71) Applicant: Huawei Technologies Co., Ltd., Shenzhen, Guangdong 518129 (CN)
(72) Inventor: ZHANG, Jiangteng, Shenzhen, 518129 (CN); MA, Zheng, Shenzhen, 518129 (CN); HUI, Libin, Shenzhen, 518129 (CN)
(74) Representative: Gill Jennings & Every LLP

(57) **Abstract**

This application relates to the field of photovoltaic technologies, and specifically, to an inverter and a photovoltaic system, to resolve problems of a high fault risk of a circuit board component and a low heat dissipation capability of the inverter. This application provides an inverter, including a connection structure and a first circuit board component. A part of the connection structure is located in a first cavity and is configured to connect to a photovoltaic module, a power grid, or a load, enabling direct current input and alternating current output. The first circuit board component is located in a second cavity and is electrically connected to the other part of the connection structure. The first circuit board component and the part of the connection structure are located in different cavities, so that separate cavity management can be implemented, and a fault risk of the first circuit board component can be reduced. In addition, a housing includes a bottom plate, a power component is located between a first circuit board and the bottom plate, and the bottom plate further includes a groove recessed toward a part of the power component, reducing a volume of the inverter while enhancing a heat dissipation capability of the inverter.

## Description

### TECHNICAL FIELD

Embodiments of this application relate to the field of photovoltaic technologies, and specifically, to an inverter and a photovoltaic system.

### BACKGROUND

An inverter includes an outer housing, a circuit board component, and a connection structure. The outer housing encloses an accommodation cavity, the circuit board component is located in the accommodation cavity, the circuit board component includes a circuit board and a power component, and the power component is disposed on the circuit board. One end of the connection structure is connected to the circuit board, and the other end of the connection structure is configured to connect to a photovoltaic module, a power grid, or a load. Both the connection structure and the circuit board component are disposed in the accommodation cavity. When a user operates the connection structure, a fault risk of the circuit board component is increased. In addition, because the connection structure and most components on the circuit board are disposed on a side that is of the circuit board and that is away from a bottom plate, the inverter exhibits a larger size and an inferior heat dissipation capability.

### SUMMARY

Embodiments of this application provide an inverter and a photovoltaic system, to implement separate cavity management, reduce a fault risk of a circuit board component, and improve a heat dissipation capability of the inverter.

According to a first aspect, this application provides an inverter, including an outer housing, a connection structure, and a first circuit board component. The outer housing includes a housing and a cover body that are disposed opposite to each other, the housing and the cover body enclose an accommodation cavity, the accommodation cavity includes a first cavity and a second cavity, and an arrangement direction of the first cavity and the second cavity is perpendicular to a thickness direction of the outer housing. A part of the connection structure is located in the first cavity and is configured to connect to a photovoltaic module, a power grid, or a load.

The first circuit board component is located in the second cavity and is electrically connected to the other part of the connection structure. The first circuit board component includes a first circuit board and a power component, and the power component is disposed on the first circuit board. The housing includes a bottom plate, heat dissipation fins are disposed on a side that is of the bottom plate and that is away from the power component, the power component is located between the first circuit board and the bottom plate, and the bottom plate further includes a groove recessed toward a part of the power component. The power component includes a power transistor, a bus capacitor, and a magnetic element.

The inverter includes the connection structure and the first circuit board component. The part of the connection structure is located in the first cavity and is configured to connect to the photovoltaic module, the power grid, or the load, and the connection structure located in the first cavity can enable direct current input and alternating current output. The first circuit board component is located in the second cavity and is electrically connected to the other part of the connection structure. The first circuit board component includes the first circuit board and the power component. The first circuit board component can implement power conversion, and convert an input direct current into an alternating current. The first circuit board component and the part of the connection structure are located in different cavities, so that separate cavity management can be implemented, a fault risk of the first circuit board component can be reduced, mutual interference between the first circuit board component and the connection structure can be reduced, and stability and reliability of the inverter can be improved.

In addition, the housing includes the bottom plate, the power component is located between the first circuit board and the bottom plate, and the bottom plate further includes the groove recessed toward the part of the power component, reducing a volume of the inverter while enhancing a heat dissipation capability of the inverter and improving power density of the inverter.

In some embodiments that may include the foregoing embodiments, the inverter further includes a direct current switch, one end of the direct current switch is connected to the other part of a first connection structure, and the other end of the direct current switch is connected to the first circuit board.

The end of the direct current switch is configured to connect to the photovoltaic module, and the other end of the direct current switch is connected to the first circuit board, so that the direct current switch can control whether a direct current from the photovoltaic module can be transmitted to the first circuit board.

In some embodiments that may include the foregoing embodiments, the housing includes a spacer plate, the spacer plate is configured to separate the housing into a first housing and a second housing, the cover body includes a first cover body and a second cover body, the first cover body, the spacer plate, and the first housing enclose the first cavity, and the second cover body, the spacer plate, and the second housing enclose the second cavity.

The spacer plate separates the housing into the first housing and the second housing, so that the first housing, the spacer plate, and the first cover body enclose the first cavity, and the second housing, the spacer plate, and the second cover body enclose the second cavity. In other words, the spacer plate separates the accommodation cavity into the first cavity and the second cavity, so that the first circuit board component and the part of the connection structure are located in different cavities, and when a user operates the connection structure located in the first cavity, normal operation of the first circuit board component is not affected.

In some embodiments that may include the foregoing embodiments, the connection structure includes a first connection structure, the first connection structure penetrates the spacer plate, a part of the first connection structure is located in the first cavity and is electrically connected to the first circuit board, and the other part of the first connection structure is located in the second cavity and is connected to the photovoltaic module.

The first connection structure is separately connected to the first circuit board and the photovoltaic module, so that a direct current generated by the photovoltaic module can be transmitted to the first circuit board, and converted into an alternating current on the first circuit board.

In some embodiments that may include the foregoing embodiments, the first housing is detachably connected to the first cover body.

The first cover body is detachably connected to the first housing. This indicates that the first housing can be used independently, and opening and closing of the first cover body do not affect a status of the second cover body. The first housing is detachably connected to the first cover body, which makes it easy to open the first cover body to check the connection structure in the first cavity.

In some embodiments that may include the foregoing embodiments, the connection structure further includes a second connection structure, the second connection structure penetrates the spacer plate, a part of the second connection structure is located in the first cavity and is electrically connected to the first circuit board, and the other part of the second connection structure is located in the second cavity and is separately connected to the load and the power grid.

The second connection structure is separately connected to the first circuit board, the load, and the power grid. In other words, an alternating current generated by the first circuit board component may be used in an on-grid photovoltaic system to supply power to the power grid and the load.

In some embodiments that may include the foregoing embodiments, the inverter further includes a second circuit board component, and the second circuit board component is located in the second cavity. The second circuit board component includes a second circuit board, a capacitor, and an inductor, the second circuit board is electrically connected to the first circuit board, and both the capacitor and the inductor are disposed on the second circuit board.

The inverter further includes a third connection structure, the third connection structure penetrates the spacer plate, a part of the third connection structure is located in the first cavity and is electrically connected to the second circuit board, and a part of the third connection structure is located in the second cavity and is connected to the load.

The second circuit board is electrically connected to the first circuit board, and the third connection structure is separately connected to the second circuit board and the load. In other words, an alternating current generated by the first circuit board can be transmitted to the second circuit board, and the second circuit board transmits the alternating current to the load via the third connection structure. The capacitor and the inductor may form a filter circuit. A changing electric field and a changing magnetic field are generated in a transmission process of the alternating current, and electromagnetic interference is generated. Therefore, the filter circuit can suppress the electromagnetic interference and ensure quality of the alternating current.

In addition, the second circuit board component is located in the second cavity, and compared with an embodiment in which the second circuit board component is located in the first cavity, this embodiment can reduce a risk of electric shock caused by possible touch of the second circuit board component when the user operates the connection structure in the first cavity. This avoids a corrosion phenomenon caused by frequent exposure of the second circuit board component, and improves operation reliability of the inverter.

In addition, the capacitor can filter out a high-frequency interference signal, and the inductor can filter out a low-frequency interference signal, to reduce the electromagnetic interference, thereby ensuring stability and reliability of the circuit.

In some embodiments that may include the foregoing embodiments, ends that are of the plurality of heat dissipation fins and that are away from the housing are aligned.

The ends that are of the plurality of heat dissipation fins and that are away from the housing are aligned. This helps optimize airflow distribution, ensures that air can be evenly in contact with each fin when passing through the heat dissipation fins, and avoids excessive or insufficient airflow in some regions.

In some embodiments that may include the foregoing embodiments, a thermal pad is disposed on a side that is of the power component and that is close to the housing, and the power component is in contact with the housing via the thermal pad.

The thermal pad can fill an air gap between the power component and the housing, so that the power component can be in full contact with the housing, thereby increasing a heat dissipation area and increasing a heat dissipation speed. In addition, the thermal pad has a high heat conductivity, which can further increase the heat dissipation speed.

In some embodiments that may include the foregoing embodiments, the inverter further includes a third circuit board, the third circuit board is located in the first cavity, the third circuit board is electrically connected to the first circuit board, and the third circuit board is configured to connect to a communication device.

The third circuit board can implement data transmission between the communication device and the inverter. The communication device can obtain a parameter setting of the inverter via the third circuit board, and monitor parameters such as an output voltage, an output current, and output power of the inverter in real time, to ensure stability of an operating status of the inverter.

According to a second aspect, an embodiment of this application further provides an inverter, including an outer housing, a connection structure, and a first circuit component. The outer housing includes a housing and a cover body that are disposed opposite to each other, the housing includes a first housing and a second housing, the cover body includes a first cover body and a second cover body, the first housing and the first cover body are disposed opposite to each other and are connected to each other, and the second housing and the second cover body are disposed opposite to each other and are detachably connected. The first housing and the first cover body enclose a first cavity, the second housing and the second cover body enclose a second cavity, and an arrangement direction of the first cavity and the second cavity is perpendicular to a thickness direction of the outer housing.

A part of the connection structure is located in the first cavity and is configured to connect to a photovoltaic module, a power grid, or a load. First circuit board component is located in the second cavity and is connected to the other part of the connection structure, first circuit board component includes a first circuit board and a power component, and the power component is disposed on the first circuit board. The second housing includes a bottom plate, heat dissipation fins are disposed on a side that is of the bottom plate and that is away from the power component, the power component is located between the first circuit board and the bottom plate, and the bottom plate further includes a groove recessed toward a part of the power component.

The inverter includes the connection structure and the first circuit board component. The part of the connection structure is located in the first cavity and is configured to connect to the photovoltaic module, the power grid, or the load, and the connection structure located in the first cavity can enable direct current input and alternating current output. The first circuit board component is located in the second cavity and is electrically connected to the other part of the connection structure. The first circuit board component includes the first circuit board and the power component. The first circuit board component can implement power conversion, and convert an input direct current into an alternating current.

The first housing and the first cover body enclose the first cavity, and the second housing and the second cover body enclose the second cavity, so that the first circuit board component and the part of the connection structure are disposed in different cavities. This implements separate cavity management, reduces a fault risk of the first circuit board component, reduces mutual interference between the first circuit board component and the connection structure, and improves stability and reliability of the inverter.

In addition, the second housing includes the bottom plate, the power component is located between the first circuit board and the bottom plate, and the bottom plate further includes the groove recessed toward the part of the power component, so that a volume of the inverter can be reduced, and power density of the inverter can be improved.

According to a third aspect, an embodiment of this application provides a photovoltaic system, including an energy storage device and an inverter. The inverter is connected to the energy storage device, and the inverter is configured to connect to a photovoltaic module and a load.

The inverter provided in this embodiment of this application includes a sampling circuit according to any one of the foregoing embodiments. Therefore, the inverter and the sampling circuit can resolve a same technical problem and achieve same technical effect.

### BRIEF DESCRIPTION OF DRAWINGS

FIG. 1 is a diagram of a structure of an inverter in a related technology;
FIG. 2 is a diagram of a structure of a photovoltaic system according to an embodiment of this application;
FIG. 3 is a diagram 1 of a structure of an inverter according to an embodiment of this application;
FIG. 4 is a sectional view in an A-A direction in FIG. 3;
FIG. 5 is a diagram 1 of a structure of an inverter with a cover body removed according to an embodiment of this application;
FIG. 6 is a diagram 2 of a structure of an inverter with a cover body removed according to an embodiment of this application;
FIG. 7 is a sectional view in a B-B direction in FIG. 3;
FIG. 8 is a diagram of a structure of a second cavity according to an embodiment of this application;
FIG. 9 is a diagram 2 of a structure of an inverter according to an embodiment of this application; and
FIG. 10 is a sectional view in a C-C direction in FIG. 9.

### Descriptions of reference numerals:

10: photovoltaic system; 11: photovoltaic module; 12: load; 13: power grid; 14: energy storage device; 20: inverter; 21: outer housing; 22: first circuit board component; 23: accommodation cavity; 23a: first cavity; 23b: second cavity; 24: second circuit board component; 30: connection structure; 31: first connection structure; 32: second connection structure; 33: third connection structure; 34: terminal; 41: first circuit board; 42: power component; 43: second circuit board; 44: electronic component; 45: inductor; 46: capacitor; 47: third circuit board; 51: housing; 51a: first housing; 51b: second housing; 511: bottom plate; 52: cover body; 52a: first cover body; 52b: second cover body; 53: heat dissipation fin; 54: groove; 55: spacer plate; 61: first through hole; 62: second through hole; 63: thermal pad; 71: direct current switch; 72: power transistor; 73: bus capacitor; 74: magnetic element; 75: DC-DC conversion circuit; and 76: DC-AC conversion circuit.

### DESCRIPTION OF EMBODIMENTS

To make objectives, technical solutions, and advantages of embodiments of this application clearer, the following clearly and completely describes the technical solutions in embodiments of this application with reference to accompanying drawings in embodiments of this application. It is clear that, the described embodiments are merely a part rather than all of embodiments of this application. Based on embodiments of this application, all other embodiments obtained by a person of ordinary skill in the art without creative efforts fall within the protection scope of this application.

Terms such as "first" and "second" mentioned below are merely intended for a purpose of description, and shall not be understood as an indication or implication of relative importance or implicit indication of a quantity of indicated technical features. Therefore, a feature defined by "first" or "second" may explicitly or implicitly include one or more features.

In addition, in embodiments of this application, orientation terms such as "up", "down", "left", "right", "horizontal", and "vertical" are defined relative to orientations in which components are schematically placed in the accompanying drawings. It should be understood that, these directional terms are relative concepts that are used for relative description and clarification, and may vary accordingly based on changes of the orientations in which the components are placed in the accompanying drawings.

In embodiments of this application, unless otherwise clearly specified and limited, a term "connection" should be understood in a broad sense. For example, the "connection" may be a fastened connection, an electrical connection, a detachable connection, or an integral connection, may be a direct connection, or an indirect connection implemented through an intermediate medium.

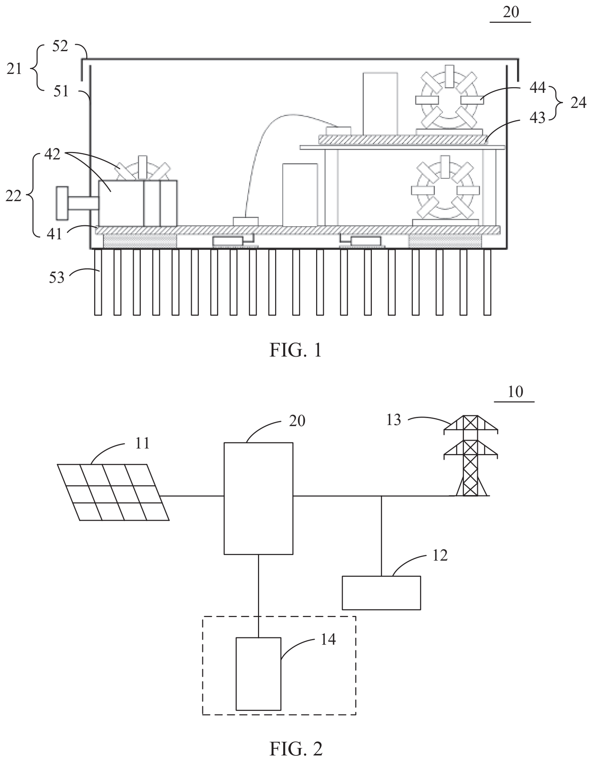

FIG. 1 shows an inverter (Inverter) 20 in a related technology. The inverter 20 includes an outer housing 21 and a first circuit board component 22. The outer housing 21 includes a housing 51 and a cover body 52 that are disposed opposite to each other. The first circuit board component 22 includes a first circuit board 41 and a power component 42, and the first circuit board 41 is disposed in a cavity enclosed by the outer housing 21. In a thickness direction of the outer housing 21, a part of the power component 42 is high and is disposed between the first circuit board 41 and the cover body 52, and a part of the power component 42 is low and is disposed between the first circuit board 41 and the housing 51.

It may be understood that the power component 42 is dispersedly disposed on two sides of the first circuit board 41, and a gap in the power component 42 is large. As a result, the inverter 20 occupies large space, and power density of the inverter 20 is low.

In an embodiment in which the inverter 20 includes a second circuit board component 24, the second circuit board component 24 includes a second circuit board 43 and an electronic component 44. The second circuit board 43 is disposed between the first circuit board 41 and the cover body 52, and the electronic component 44 is disposed between the second circuit board 43 and the cover body 52.

It may be understood that the power component 42 is located between the first circuit board 41 and the second circuit board 43, and a distance between the first circuit board 41 and the second circuit board 43 is long. As a result, a transmission line connecting the first circuit board 41 and the second circuit board 43 is long, and a signal is easily attenuated in a transmission process. In addition, a high support needs to be disposed when the second circuit board 43 is disposed, which increases costs.

Refer to FIG. 2. This application provides a photovoltaic system 10, including an inverter 20. A part of a connection structure of the inverter 20 is connected to a photovoltaic module 11, one end of the inverter 20 is connected to the photovoltaic module 11, and the other end of the inverter 20 is connected to a load 12. The inverter 20 may receive a direct current from the photovoltaic module 11, convert the direct current into an alternating current inside the inverter 20, and transmit the alternating current to the load 12 to supply power to the load 12.

It may be understood that the photovoltaic system 10 includes two main types: an on-grid photovoltaic system and an off-grid photovoltaic system. In an embodiment in which the photovoltaic system 10 includes the on-grid photovoltaic system, the other end of the inverter 20 is further connected to a power grid 13. When electric energy generated by the inverter 20 is greater than power consumed by the load 12, a redundant alternating current may be transmitted to the power grid 13 for use of the power grid 13. When the power consumed by the load 12 is greater than the electric energy generated by the inverter 20, electric energy may be purchased from the power grid 13.

In an embodiment in which the photovoltaic system 10 includes the off-grid photovoltaic system, the inverter 20 is not connected to the power grid 13, the photovoltaic system 10 further includes an energy storage device 14, and the inverter 20 is connected to the energy storage device 14. When the electric energy generated by the inverter 20 is greater than the power consumed by the load 12, the redundant alternating current may be transmitted to the energy storage device 14. When the electric energy generated by the inverter 20 is less than the power consumed by the load 12, the electric energy in the energy storage device 14 may be transmitted to the load 12 via the inverter 20.

It may be understood that there are two types of wiring between the inverter 20 and the load 12, which are respectively an on-grid cable and an off-grid cable. A distribution board is disposed between the inverter 20 and the load 12, the inverter 20 is connected to the distribution board through the on-grid cable and the off-grid cable, and the distribution board is connected to the load 12. The distribution board may convert an alternating current received by the load 12, so that the alternating current generated by the off-grid photovoltaic system or the alternating current generated by the on-grid photovoltaic system is transmitted to the load 12.

It may be understood that the inverter 20 may be further connected to a management system. The inverter 20 may transmit data such as parameter information, an input voltage, and an output voltage to the management system, and the management system may control an input and an output of the inverter 20 in real time based on the data.

The inverter 20 may be further connected to a detection apparatus. One end of the detection apparatus is connected to the inverter 20, and the other end of the detection apparatus is connected to the power grid 13. The voltage detection apparatus may detect amount of power transmitted by the inverter 20 to the power grid 13, to avoid that the amount of power transmitted by the inverter 20 to the power grid 13 exceeds a preset value and affects normal operation of the power grid 13.

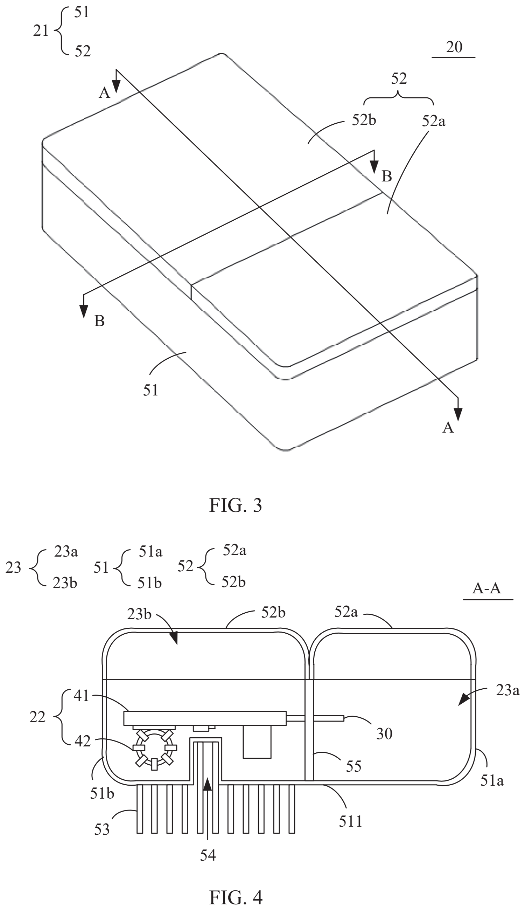

Refer to FIG. 3 and FIG. 4. The inverter 20 provided in this application includes an outer housing 21. The outer housing 21 includes a housing 51 and a cover body 52 that are disposed opposite to each other. The housing 51 and the cover body 52 enclose an accommodation cavity 23. The accommodation cavity 23 includes a first cavity 23a and a second cavity 23b, and an arrangement direction of the first cavity 23a and the second cavity 23b is perpendicular to a thickness direction of the outer housing 21.

The inverter 20 further includes a connection structure 30 and a first circuit board component 22. A part of the connection structure 30 is located in the first cavity 23a and is configured to connect to the photovoltaic module 11, the power grid 13, or the load 12. The first circuit board component 22 is located in the second cavity 23b and is electrically connected to the other part of the connection structure 30. The first circuit board component 22 includes a first circuit board 41 and a power component 42, and the power component 42 is disposed on the first circuit board 41.

The connection structure 30 can implement an electrical connection between the first circuit board component 22 and the photovoltaic module 11 (shown in FIG. 2), and transmit a direct current to the first circuit board component 22. The first circuit board component 22 includes the power component 42, and the power component 42 can implement conversion from an alternating current to a direct current. The connection structure 30 can further implement an electrical connection between the first circuit board component 22 and the power grid 13 (shown in FIG. 2) or the load 12 (shown in FIG. 2), and transmit a direct current generated by the first circuit board component 22 to the load 12 or the power grid 13.

The housing 51 includes a bottom plate 511, heat dissipation fins 53 are disposed on a side that is of the bottom plate 511 and that is away from the power component 42, the power component 42 is located between the first circuit board 41 and the bottom plate 511, and the bottom plate 511 further includes a groove 54 recessed toward a part of the power component 42. It may be understood that a large amount of heat is generated when the power component 42 operates, and the heat dissipation fins 53 can increase a heat dissipation area of the housing 51, to transfer the heat generated by the power component 42 to external air.

The power component 42 is located between the first circuit board 41 and the bottom plate 511, so that a distance between the power component 42 and the heat dissipation fins 53 is reduced, a contact area between the power component 42 and the housing 51 can be increased, and a heat dissipation speed of the power component 42 can be increased. The power component 42 includes at least one of a direct current switch, a power transistor, a bus capacitor, a magnetic element, and a capacitor.

The bottom plate 511 further includes the groove 54 recessed toward the part of the power component 42. It may be understood that the power component 42 includes a power transistor, a capacitor, an inductor, and the like. A thickness of the power transistor is less than a thickness of the capacitor, and a part of the bottom plate 511 corresponding to the power transistor is recessed toward the power transistor, so that the groove 54 is correspondingly formed on a side that is of the bottom plate 511 and that is away from the first circuit board 41.

The inverter 20 includes the connection structure 30 and the first circuit board component 22. The part of the connection structure 30 is located in the first cavity 23a and is configured to connect to the photovoltaic module 11, the power grid 13, or the load 12. The connection structure 30 located in the first cavity 23a can enable direct current input and alternating current output.

The first circuit board component 22 is located in the second cavity 23b and is electrically connected to the other part of the connection structure 30. The first circuit board component 22 includes the first circuit board 41 and the power component 42. The first circuit board component 22 can implement power conversion, and convert an input direct current into an alternating current. The first circuit board component 22 and the part of the connection structure 30 are located in different cavities, so that separate cavity (Separate cavity) management can be implemented, a fault risk of the first circuit board component 22 can be reduced, mutual interference between the first circuit board component 22 and the connection structure 30 can be reduced, and stability and reliability of the inverter 20 can be improved.

In addition, compared with the related technology in FIG. 1, the housing 51 in this application includes the bottom plate 511, the power component 42 is located between the first circuit board 41 and the bottom plate 511, and the bottom plate 511 further includes the groove 54 recessed toward the part of the power component 42, reducing a volume of the inverter 20 while enhancing a heat dissipation capability of the inverter 20 and improving power density of the inverter 20.

In the foregoing embodiments, the housing 51 includes a spacer plate 55, the spacer plate 55 is configured to separate the housing 51 into a first housing 51a and a second housing 51b, the cover body 52 includes a first cover body 52a and a second cover body 52b, the first housing 51a, the spacer plate 55, and the first cover body 52a enclose the first cavity 23a, and the second housing 51b, the spacer plate 55, and the second cover body 52b enclose the second cavity 23b.

The spacer plate 55 separates the housing 51 into the first housing 51a and the second housing 51b, so that the first housing 51a, the spacer plate 55, and the first cover body 52a enclose the first cavity 23a, and the second housing 51b, the spacer plate 55, and the second cover body 52b enclose the second cavity 23b. In other words, the spacer plate 55 separates the accommodation cavity 23 into the first cavity 23a and the second cavity 23b, so that the first circuit board component 22 and the part of the connection structure 30 are located in different cavities, and when a user operates the connection structure 30 located in the first cavity 23a, normal operation of the first circuit board component 22 is not affected.

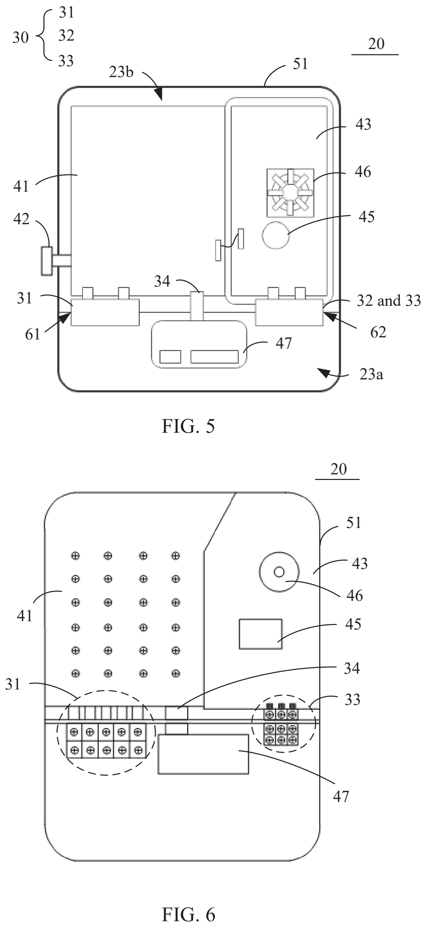

Refer to FIG. 5 and FIG. 6. In the foregoing embodiments, the connection structure 30 includes a first connection structure 31, the first connection structure 31 penetrates the spacer plate 55, a part of the first connection structure 31 is located in the first cavity 23a and is electrically connected to the first circuit board 41, and the other part of the first connection structure 31 is located in the second cavity 23b and is connected to the photovoltaic module 11.

It may be understood that a first through hole 61 may be disposed on the spacer plate 55, and the first connection structure 31 may pass through the first through hole 61 and be separately connected to the first circuit board 41 and the photovoltaic module 11 (shown in FIG. 2).

The first connection structure 31 is separately connected to the first circuit board 41 and the photovoltaic module 11, so that a direct current generated by the photovoltaic module 11 can be transmitted to the first circuit board 41, and converted into an alternating current on the first circuit board 41.

In some embodiments, a rubber pad may be disposed between the spacer plate 55 and the first connection structure 31. A material of the rubber pad is soft and deformable. There may be a gap between the spacer plate 55 and the first connection structure 31, and the rubber pad may fill the gap, to improve air tightness of the first cavity 23a and the second cavity 23b.

In the foregoing embodiments, the first housing 51a is detachably connected to the first cover body 52a. A connection manner between the first housing 51a and the first cover body 52a is not limited in this embodiment of this application. For example, the first housing 51a and the first cover body 52a may be connected by using a screw bolt structure, and the first housing 51a and the first cover body 52a may alternatively be connected by using a buckle structure.

The first cover body 52a is detachably connected to the first housing 51a, so that the first housing 51a can be used independently, and opening and closing of the first cover body 52a do not affect a status of the second cover body 52b. The first housing 51a is detachably connected to the first cover body 52a, which makes it easy to open the first cover body 52a to check the connection structure 30 in the first cavity 23a.

In the foregoing embodiments, the first connection structure 31 includes a feed-through terminal 34. It may be understood that the first connection structure 31 is configured to transmit the direct current generated by the photovoltaic module 11. In other words, the first connection structure 31 may be a photovoltaic (Photovoltaic, briefly referred to as PV) feed-through terminal.

Still refer to FIG. 5 and FIG. 6. In the foregoing embodiments, the connection structure 30 further includes a second connection structure 32, the second connection structure 32 penetrates the spacer plate 55, a part of the second connection structure 32 is located in the first cavity 23a and is electrically connected to the first circuit board 41, and the other part of the second connection structure 32 is located in the second cavity 23b and is separately connected to the load 12 (shown in FIG. 2) and the power grid 13 (shown in FIG. 2).

It may be understood that a second through hole 62 may be disposed on the spacer plate 55, and the second connection structure 32 may pass through the second through hole 62 and be separately connected to the first circuit board 41, the load 12, and the power grid 13.

The second connection structure 32 is separately connected to the first circuit board 41, the load 12, and the power grid 13. In other words, an alternating current generated by the first circuit board component 22 may be used in the on-grid photovoltaic system to supply power to the power grid 13 and the load 12.

Because the second connection structure 32 is configured to transmit the alternating current generated by the inverter 20, in an embodiment in which the connection structure 30 is the feed-through terminal, the second connection structure 32 may be an alternating current (Alternating Current, briefly referred to as AC) feed-through terminal.

In some embodiments, a rubber pad may also be disposed between the spacer plate 55 and the second connection structure 32, to improve air tightness of the first cavity 23a and the second cavity 23b. This is similar to the rubber pad in the foregoing embodiments. Details are not described herein again.

Refer to FIG. 5, FIG. 6, and FIG. 7. In the foregoing embodiments, the inverter 20 further includes a second circuit board component 24, and the second circuit board component 24 is located in the second cavity 23b. The second circuit board component 24 includes a second circuit board 43, a capacitor 46, and an inductor 45. The second circuit board 43 is electrically connected to the first circuit board 41, and both the capacitor 46 and the inductor 45 are disposed on the second circuit board 43.

The inverter 20 further includes a third connection structure 33, the third connection structure 33 penetrates the spacer plate 55, a part of the third connection structure 33 is located in the first cavity 23a and is electrically connected to the second circuit board 43, and a part of the third connection structure 33 is located in the second cavity 23b and is connected to the load 12.

The second circuit board 43 is electrically connected to the first circuit board 41, and the third connection structure 33 is separately connected to the second circuit board 43 and the load 12. In other words, an alternating current generated by the first circuit board 41 can be transmitted to the second circuit board 43, and the second circuit board 43 transmits the alternating current to the load 12 via the third connection structure 33.

It may be understood that the third connection structure 33 is connected only to the load 12, and may be used in the off-power grid (off-power grid) photovoltaic system. The second circuit board 43 is configured to transmit the alternating current, so that the alternating current generated by the first circuit board 41 can be transmitted to the load 12. The second circuit board 43 may also be referred to as an output board.

The capacitor 46 and the inductor 45 may form a filter circuit. A changing electric field and a changing magnetic field are generated in a transmission process of the alternating current, and electromagnetic interference is generated. Therefore, the filter circuit can suppress the electromagnetic interference and ensure quality of the output alternating current.

In addition, the second circuit board component 24 is located in the second cavity 23b, and compared with an embodiment in which the second circuit board component 24 is located in the first cavity 23a, this embodiment can reduce a risk of electric shock caused by possible touch of the second circuit board component 24 when the user operates the connection structure 30 in the first cavity 23a. This avoids a corrosion phenomenon caused by frequent exposure of the second circuit board component 24, and improves operation reliability of the inverter 20.

In addition, the capacitor 46 can filter out a high-frequency interference signal, and the inductor 45 can filter out a low-frequency interference signal, to reduce the electromagnetic interference, thereby ensuring stability and reliability of the circuit.

In some embodiments, a third through hole may be disposed on the spacer plate 55, and the third connection structure 33 may pass through the third through hole and be separately connected to the second circuit board 43 and the load 12.

In some embodiments, the second connection structure 32 and the third connection structure 33 are of an integrated structure. The second connection structure 32 located in the second cavity 23b may be connected to the first circuit board 41 via a first copper bar, and the third connection structure 33 may be connected to the second circuit board 43 via a second copper bar.

The second connection structure 32 and the third connection structure 33 are of the integrated structure, so that manufacturing costs and processing steps can be reduced. In addition, the second connection structure 32 and the third connection structure 33 need to penetrate the spacer plate 55. The second connection structure 32 and the third connection structure 33 are of the integrated structure, so that a quantity of holes on the spacer plate 55 can be reduced, and the air tightness of the first cavity 23a and the second cavity 23b can be ensured.

In some embodiments, a rubber pad may also be disposed between the spacer plate 55 and the third connection structure 33, to improve the air tightness of the first cavity 23a and the second cavity 23b. This is similar to the rubber pad in the foregoing embodiments. Details are not described herein again.

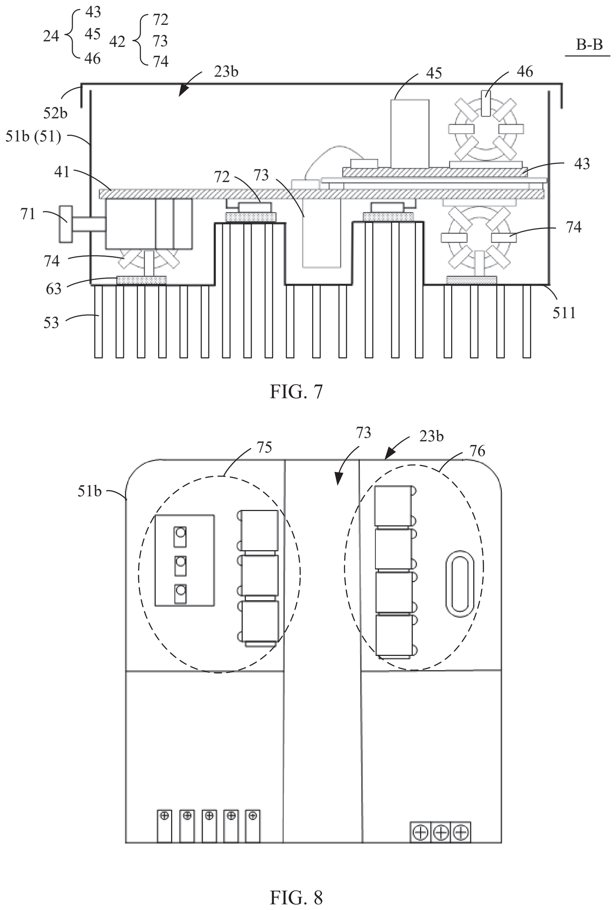

Refer to FIG. 7. In the foregoing embodiments, ends that are of the plurality of heat dissipation fins 53 and that are away from the housing 51 are aligned. It may be understood that the bottom plate 511 includes the groove 54 recessed toward the part of the power component 42. In other words, a length of the heat dissipation fins 53 in the groove 54 is greater than a length of the remaining heat dissipation fins 53 on the housing 51, so that the ends that are of the plurality of heat dissipation fins 53 and that are away from the housing 51 can be may be aligned.

The ends that are of the plurality of heat dissipation fins 53 and that are away from the housing 51 are aligned. This helps optimize airflow distribution, ensures that air can be evenly in contact with each fin when passing through the heat dissipation fins 53, and avoids excessive or insufficient airflow in some regions.

In the foregoing embodiments, a thermal pad 63 is disposed on a side that is of the power component 42 and that is close to the housing 51, and the power component 42 is in contact with the housing 51 via the thermal pad 63.

The thermal pad 63 can fill an air gap between the power component 42 and the housing 51, so that the power component 42 can be in full contact with the housing 51, thereby increasing the heat dissipation area and increasing the heat dissipation speed. In addition, the thermal pad 63 has a high heat conductivity, which can further increase the heat dissipation speed.

Still refer to FIG. 6 and FIG. 7. In the foregoing embodiments, the inverter 20 further includes a direct current switch 71, one end of the direct current switch 71 is connected to the other part of the first connection structure 31, and the other end of the direct current switch 71 is connected to the first circuit board 41.

The end of the direct current switch 71 is configured to connect to the photovoltaic module 11 (shown in FIG. 2), and the other end of the direct current switch 71 is connected to the first circuit board 41, so that the direct current switch 71 can control whether the direct current from the photovoltaic module 11 can be transmitted to the first circuit board 41.

Refer to FIG. 7 and FIG. 8. In the foregoing embodiments, the power component 42 includes a power transistor 72, a bus capacitor 73, and a magnetic element 74.

It may be understood that the power transistor 72 and the magnetic element 74 may form a DC-DC (Direct Current to Direct Current) conversion circuit 75 and a DC-AC (Direct Current to Alternating Current) conversion circuit 76, to implement conversion from a direct current to a direct current and conversion from a direct current to an alternating current.

The bus capacitor 73 may be separately connected to an output end of the DC-DC conversion circuit 75 and an input end of the DC-AC conversion circuit 76. The bus capacitor 73 may store energy, to reduce fluctuation of a direct current, so as to ensure stability of an output alternating current. When a voltage of the output alternating current changes, the bus capacitor 73 may stabilize the output of the alternating current by storing and releasing electric charges. The bus capacitor 73 may further prevent a voltage and a current in the circuit from being excessively high, to protect the another power component 42.

Still refer to FIG. 5. In the foregoing embodiments, the inverter 20 further includes a third circuit board 47, the third circuit board 47 is located in the first cavity 23a, the third circuit board 47 is electrically connected to the first circuit board 41, and the third circuit board 47 is configured to connect to a communication device.

The third circuit board 47 can implement data transmission between the communication device and the inverter 20. The communication device can obtain a parameter setting of the inverter 20 via the third circuit board 47, and monitor parameters such as an output voltage, an output current, and output power of the inverter 20 in real time, to ensure stability of an operating status of the inverter 20.

It may be understood that a voltage on the third circuit board 47 is a safety extra-low voltage (Safety Extra-Low Voltage Circuit, briefly referred to as SELV). When the user opens the first cover body 52a to operate the connection structure 30, there is no risk of electric shock even if the user touches the third circuit board 47.

In some embodiments, a fourth through hole may be disposed on the spacer plate 55, and the terminal 34 may pass through the fourth through hole and be separately connected to the third circuit board 47 and the first circuit board 41.

In some embodiments, a rubber pad may also be disposed between the spacer plate 55 and the terminal 34, to improve the air tightness of the first cavity 23a and the second cavity 23b. This is similar to the rubber pad in the foregoing embodiments. Details are not described herein again.

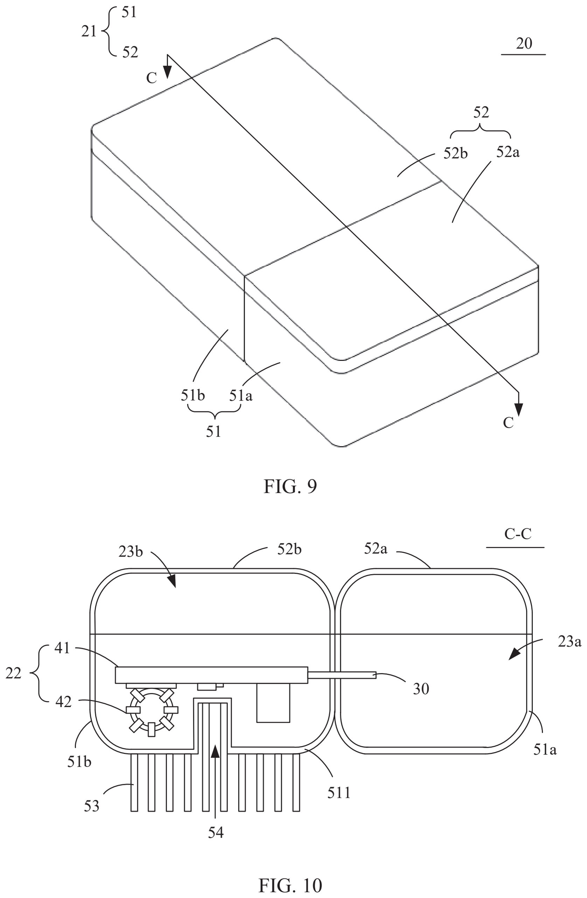

Refer to FIG. 9 and FIG. 10. An embodiment of this application further provides an inverter 20, including an outer housing 21, a connection structure 30, and a first circuit board component. The outer housing 21 includes a housing 51 and a cover body 52 that are disposed opposite to each other, the housing 51 includes a first housing 51a and a second housing 51b, the cover body 52 includes a first cover body 52a and a second cover body 52b, the first housing 51a and the first cover body 52a are disposed opposite to each other and are connected to each other, and the second housing 51b and the second cover body 52b are disposed opposite to each other and are detachably connected. The first housing 51a and the first cover body 23a enclose a first cavity 23a, the second housing 51b and the second cover body 52b enclose a second cavity 23b, and an arrangement direction of the first cavity 23a and the second cavity 23b is perpendicular to a thickness direction of the outer housing 21.

A part of the connection structure 30 is located in the first cavity 23a and is configured to connect to the photovoltaic module 11 (shown in FIG. 2), the power grid 13 (shown in FIG. 2), or the load 12 (shown in FIG. 2). First circuit board component is located in the second cavity 23b and is connected to the other part of the connection structure 30, first circuit board component includes a first circuit board 41 and a power component 42, and the power component 42 is disposed on the first circuit board 41.

The connection structure 30 can implement an electrical connection between the first circuit board component 22 and the photovoltaic module 11, and transmit a direct current to the first circuit board component 22. The first circuit board component 22 includes the power component 42, and the power component 42 can implement conversion from an alternating current to a direct current. The connection structure 30 can further implement an electrical connection between the first circuit board component 22 and the power grid 13 or the load 12, and transmit a direct current generated by the first circuit board component 22 to the load 12 or the power grid 13.

The second housing 51b includes a bottom plate 511, heat dissipation fins 53 are disposed on a side that is of the bottom plate 511 and that is away from the power component 42, the power component 42 is located between the first circuit board 41 and the bottom plate 511, and the bottom plate 511 further includes a groove 54 recessed toward a part of the power component 42. It may be understood that a large amount of heat is generated when the power component 42 operates, and the heat dissipation fins 53 can increase a heat dissipation area of the housing 51, to transfer the heat generated by the power component 42 to external air.

The power component 42 is located between the first circuit board 41 and the bottom plate 511, so that a distance between the power component 42 and the heat dissipation fins 53 is reduced, a contact area between the power component 42 and the second housing 51b can be increased, and a heat dissipation speed of the power component 42 can be increased.

The bottom plate 511 further includes the groove 54 recessed toward the part of the power component 42. It may be understood that the power component 42 includes a power transistor 72, a capacitor 46, an inductor 45, and the like. A thickness of the power transistor 72 is less than a thickness of the capacitor 46, and a part of the bottom plate 511 corresponding to the power transistor 72 is recessed toward the power transistor 72, so that the groove 54 is correspondingly formed on a side that is of the bottom plate 511 and that is away from the first circuit board 41.

The inverter 20 includes the connection structure 30 and the first circuit board component 22. The part of the connection structure 30 is located in the first cavity 23a and is configured to connect to the photovoltaic module 11, the power grid 13, or the load 12. The connection structure 30 located in the first cavity 23a can enable direct current input and alternating current output.

The first circuit board component 22 is located in the second cavity 23b and is electrically connected to the other part of the connection structure 30. The first circuit board component 22 includes the first circuit board 41 and the power component 42. The first circuit board component 22 can implement power conversion, and convert an input direct current into an alternating current.

The first housing 51a and the first cover body 52a enclose the first cavity 23a, and the second housing 51b and the second cover body 52b enclose the second cavity 23b, so that the first circuit board component 22 and the part of the connection structure 30 are disposed in different cavities. This implements separate cavity management, reduces a fault risk of the first circuit board component 22, reduces mutual interference between the first circuit board component 22 and the connection structure 30, and improves stability and reliability of the inverter 20.

In addition, the second housing 51b includes the bottom plate 511, the power component 42 is located between the first circuit board 41 and the bottom plate 511, and the bottom plate 511 further includes the groove 54 recessed toward the part of the power component 42, so that a volume of the inverter 20 can be reduced, and power density of the inverter 20 can be improved.

In addition to being applied to the inverter, this application may be further applied to an on-board charger, an uninterruptible power supply (Uninterruptible Power Supply, briefly referred to as UPS), and the like.

Finally, it should be noted that the foregoing embodiments are merely intended for describing the technical solutions of embodiments of this application but not for limiting this application. Although this application is described in detail with reference to the foregoing embodiments, a person of ordinary skill in the art should understand that modifications may still be made to the technical solutions described in the foregoing embodiments or equivalent replacements are made to a part or all technical features thereof, without departing from the scope of the technical solutions of embodiments of this application.

## Claims

1. An inverter, comprising:
an outer housing, comprising a housing and a cover body that are disposed opposite to each other, wherein the housing and the cover body enclose an accommodation cavity, the accommodation cavity comprises a first cavity and a second cavity, and an arrangement direction of the first cavity and the second cavity is perpendicular to a thickness direction of the outer housing;
a connection structure, wherein a part of the connection structure is located in the first cavity and is configured to connect to a photovoltaic module, a power grid, or a load; and
a first circuit board component, located in the second cavity and electrically connected to the other part of the connection structure, wherein the first circuit board component comprises a first circuit board and a power component, and the power component is disposed on the first circuit board, wherein
the housing comprises a bottom plate, heat dissipation fins are disposed on a side that is of the bottom plate and that is away from the power component, the power component is located between the first circuit board and the bottom plate, and the bottom plate further comprises a groove recessed toward a part of the power component; and
the power component comprises a power transistor, a bus capacitor, and a magnetic element.

2. The inverter according to claim 1, wherein the housing comprises a spacer plate, the spacer plate is configured to separate the housing into a first housing and a second housing, the cover body comprises a first cover body and a second cover body, the first cover body, the spacer plate, and the first housing enclose the first cavity, and the second cover body, the spacer plate, and the second housing enclose the second cavity.

3. The inverter according to claim 2, wherein the first housing is detachably connected to the first cover body.

4. The inverter according to any one of claims 1 to 3, wherein the connection structure comprises a first connection structure, the first connection structure penetrates the spacer plate, a part of the first connection structure is located in the first cavity and is electrically connected to the first circuit board, and the other part of the first connection structure is located in the second cavity and is connected to the photovoltaic module.

5. The inverter according to claim 4, wherein the first connection structure comprises a feed-through terminal.

6. The inverter according to claim 4 or 5, wherein the inverter further comprises a direct current switch, one end of the direct current switch is connected to the other part of the first connection structure, and the other end of the direct current switch is connected to the first circuit board.

7. The inverter according to any one of claims 1 to 6, wherein the connection structure further comprises a second connection structure, the second connection structure penetrates the spacer plate, a part of the second connection structure is located in the first cavity and is electrically connected to the first circuit board, and the other part of the second connection structure is located in the second cavity and is separately connected to the load and the power grid.

8. The inverter according to any one of claims 1 to 7, wherein the inverter further comprises a second circuit board component, and the second circuit board component is located in the second cavity;
the second circuit board component comprises a second circuit board, a capacitor, and an inductor, the second circuit board is electrically connected to the first circuit board, both the capacitor and the inductor are disposed on the second circuit board, the second circuit board is located between the first circuit board and a top plate of the cover body, and both the capacitor and the inductor are located between the second circuit board and the top plate of the cover body; and
the inverter further comprises a third connection structure, the third connection structure penetrates the spacer plate, a part of the third connection structure is located in the first cavity and is electrically connected to the second circuit board, and the other partt of the third connection structure is located in the second cavity and is connected to the load.

9. The inverter according to any one of claims 1 to 8, wherein ends that are of the plurality of heat dissipation fins and that are away from the housing are aligned.

10. The inverter according to any one of claims 1 to 9, wherein a thermal pad is disposed on a side that is of the power component and that is close to the housing, and the power component is in contact with the housing via the thermal pad.

11. The inverter according to any one of claims 1 to 10, wherein the inverter further comprises a third circuit board, the third circuit board is located in the first cavity, the third circuit board is electrically connected to the first circuit board, and the third circuit board is configured to connect to a communication device.

12. An inverter, comprising:
an outer housing, comprising a housing and a cover body that are disposed opposite to each other, wherein the housing comprises a first housing and a second housing, the cover body comprises a first cover body and a second cover body, the first housing and the first cover body are disposed opposite to each other and are connected to each other, and the second housing and the second cover body are disposed opposite to each other and are detachably connected; and
the first housing and the first cover body enclose a first cavity, the second housing and the second cover body enclose a second cavity, and an arrangement direction of the first cavity and the second cavity is perpendicular to a thickness direction of the outer housing;
a connection structure, wherein a part of the connection structure is located in the first cavity and is configured to connect to a photovoltaic module, a power grid, or a load; and
a first circuit board component, located in the second cavity and connected to the other part of the connection structure, wherein first circuit board component comprises a first circuit board and a power component, the power component is disposed on the first circuit board, the second housing comprises a bottom plate, heat dissipation fins are disposed on a side that is of the bottom plate and that is away from the power component, the power component is located between the first circuit board and the bottom plate, and the bottom plate further comprises a groove recessed toward a part of the power component.

13. A photovoltaic system, comprising an energy storage device and the inverter according to any one of claims 1 to 12, wherein the inverter is connected to the energy storage device, and the inverter is configured to connect to a photovoltaic module and a load.
